# EUROPEAN PATENT APPLICATION

(11) **EP 2 290 817 A1**
(43) Date of publication of application: **02.03.2011**
(21) Application number: 09766364.5
(22) Date of filing: 19.05.2009
(51) Int. Cl.: H03H 9/25, H03H 9/145, H03H 9/64

(54) **ELASTIC BOUNDARY WAVE DEVICE**

(30) Priority: 16.06.2008 JP 2008156283
(71) Applicant: Murata Manufacturing Co. Ltd., Nagaokakyo-shi, Kyoto 617-8555 (JP)
(72) Inventor: HARUTA, Kazumasa, Nagaokakyo-shi Kyoto 617-8555 (JP)
(74) Representative: Thévenet, Jean-Bruno
(86) International application number: PCT/JP2009/002193
(87) International publication number: WO 2009/153916

(57) **Abstract**

A boundary acoustic wave device is provided which can increase the attenuation outside of a passband and allows reduction in size without providing a structure for adding large capacitance. A boundary acoustic wave device (1) in which an electrode structure is provided at the interface between a piezoelectric substrate and a dielectric layer, and the electrode structure constitutes a ladder fitter, where at least two ground pads of a plurality of ground pads (28 to 31), to be connected to a ground potential, provided on the piezoelectric substrate (11) are electrically connected by a connection conductor (32) provided on the dielectric layer (12,) and all the ground pads (28 to 31) are electrically connected.

## Description

### Technical Field

The present invention relates to a boundary acoustic wave device having an electrode structure formed at the interface between a piezoelectric substrate and a dielectric layer, and more specifically to a boundary acoustic wave device in which a filter having a ladder circuit configuration is configured.

### Background Art

It is strongly required that a band pass filter and the like used in cellular phones have a large amount of attenuation in bands outside of a passband. Hitherto, a surface acoustic wave filter device has been widely used as such a band pass filter.

Fig. 10 is a circuit diagram showing the surface acoustic wave filter device disclosed in Patent Document 1. The surface acoustic wave filter device 1001 has a series arm that connects an input terminal 1002 and an output terminal 1003. On the series arm, series arm resonators 1004 to 1006 are connected in series. A plurality of parallel arms are connected to the series arm. Each of the parallel arms has a parallel arm resonator 1007.

Inductors L are respectively connected between the input terminal 1002 and the series arm resonator 1004, and between the series arm resonator 1006 and the output terminal 1003. Inductors L are also respectively connected to the ends of the parallel arm resonators 1007. These inductors L represent inductance components of wiring lines, connection portions, or bonding wires between the surface acoustic wave resonator chips and a package on which the chips are mounted.

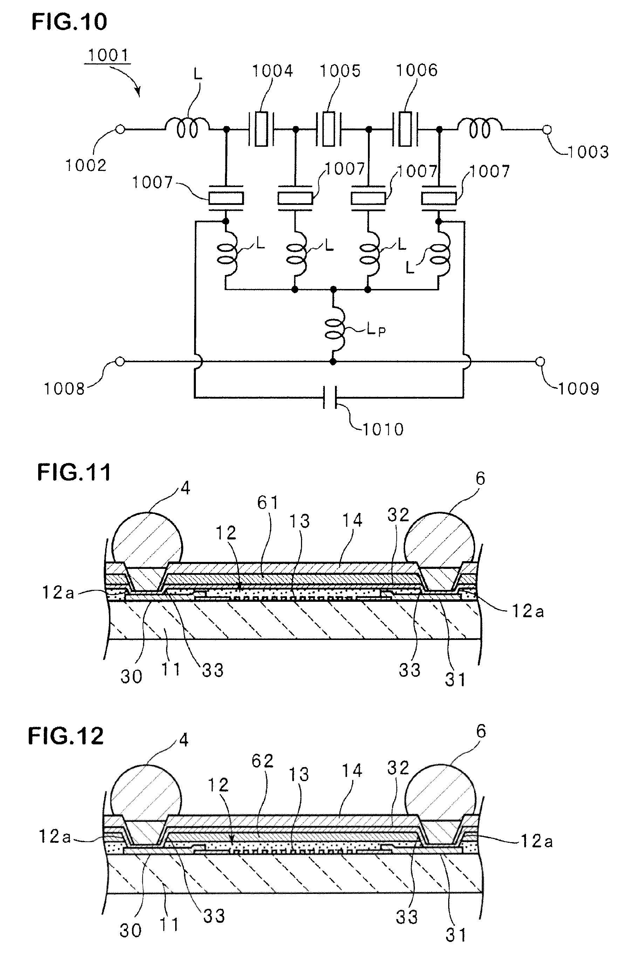

An inductor Lp shown in Fig. 10 represents an inductance component of the portions from the connection pads on the package to the ground electrodes of an apparatus where the surface acoustic wave filter devices 1001 is mounted, in other words, ground electrodes 1008 and 1009 shown in Fig. 10.

In the surface acoustic wave filter device 1001, a capacitor 1010 is connected between the end of the parallel arm closest to the input terminal 1002 and the parallel arm closet to the output terminal 1003.

The attenuation in a band lower than a passband can be increased while keeping the width of the passband, by making the inductance component Lp extremely small and choosing an appropriate value for the inductance component L. In actual surface acoustic wave devices, however, it is very difficult to make the value of the inductance component Lp small due to restrictions on wiring of lines and the like. Hence in the surface acoustic wave filter device disclosed in Patent Document 1, it is made possible to increase the attenuation outside of the passband without decreasing the inductance component Lp by providing the capacitor 1010 described above.

On the other hand, a boundary acoustic wave filter device, which realizes further reduction in size, has recently drawn attention as an alternative to a surface acoustic wave filter device.

### Prior Art Document

### Patent Document

Patent Document 1: Japanese Unexamined Patent Application Publication No. 2003-101384

### Disclosure of Invention

### Problems to be Solved by the Invention

In the surface acoustic wave filter device disclosed in Patent Document 1, the attenuation outside of a passband is increased by providing the capacitor 1010. However, such a configuration is effective when a structure having a high inductance such as a bonding wire is connected to the ground terminal of the parallel arm resonator in a ladder filter.

In a boundary acoustic wave device, on the other hand, an electrode structure for exciting boundary acoustic waves is arranged at the interface between a piezoelectric layer and a dielectric layer, and embedded in a boundary acoustic wave device chip. Hence, a package is not required, and the wiring lines do not have a large inductance component. Consequently, the method of increasing the attenuation outside of a passband by using the inductance component L and the capacitor 1010 described in Patent Document 1 is not effective for a boundary acoustic wave device.

Although there may be a method of providing inductance and capacitance by connection of an external device, this method will significantly diminish the advantage of a reduction in the size of a boundary acoustic wave device.

It is an object of the present invention to provide a boundary acoustic wave device, having a ladder circuit configuration, which solves the above issues of the known technology and increases the attenuation outside of a passband, and hence, advantageously allows reduction in size.

### Means for Solving the Problems

According to the present invention, a boundary acoustic wave device is provided which includes: a piezoelectric substrate; a first dielectric layer formed on the piezoelectric substrate; and an electrode structure provided at an interface between the piezoelectric substrate and the first dielectric layer. The electrode structure has: a plurality of series arm resonators connected to one another in series on a series arm that connects an input terminal and an output terminal; a parallel arm resonator connected between the series arm and a ground potential on each of a plurality of parallel arms provided between the series arm and the ground potential; a plurality of ground wiring lines respectively connected to ends, to be connected to the ground potential, of the plurality of the parallel arms; and a plurality of ground pads respectively connected to the plurality of the ground wiring lines. The electrode structure constitutes a ladder filter. The boundary acoustic wave device further includes: a signal wiring line constituting the series arm arranged in such a manner as to be located between at least two of the plurality of the ground pads; and a ground connection conductor for electrically connecting the at least two ground pads. The signal wiring line three-dimensionally crosses the ground connection conductor with the first dielectric layer therebetween, and all the ground pads are electrically connected.

In a specific aspect of the boundary acoustic wave device according to the present embodiment, the signal wiring line is formed on the piezoelectric substrate, the ground connection conductor is electrically connected to the at least two ground pads through via hole conductors formed in and extending through the first dielectric layer, and the signal wiring line three-dimensionally crosses the ground connection conductor with the first dielectric layer therebetween. In this case, using three-dimensional crossing allows an increase in wiring density and a further reduction in the size of the boundary acoustic wave device.

In another specific aspect of the boundary acoustic wave device according to the present invention, the ground connection conductor is electrically connected to all the ground pads. In this case, all the ground pads are electrically connected by the ground connection conductor, and grounding is reliably strengthened. In addition, the configuration in which all the ground pads are connected by the ground connection conductor allows simplification of the electrode structure on the piezoelectric substrate, since separate ground wiring lines are not necessarily required for electrically connecting the ground pads to one another on the piezoelectric substrate.

In still another specific aspect of the boundary acoustic wave device according to the present invention, capacitance is formed in a facing portion where the ground connection conductor faces the ground wiring line with the first dielectric layer therebetween. In this case, since the ground connection conductor is coupled with the ground potential by the capacitance, grounding is further strengthened.

In still another specific aspect of the boundary acoustic wave device according to the present invention, a portion of the signal wiring line is formed on the first dielectric layer, and is electrically connected to the other portions of the signal line through via hole conductors extending through the first dielectric layer, the ground connection conductor is formed on the piezoelectric substrate, and the portion of the signal wiring line three-dimensionally crosses the ground connection conductor with the first dielectric layer therebetween.

In still another specific aspect of the boundary acoustic wave device according to the present invention, the ladder filter has a first filter circuit portion arranged on an input end side and a second filter circuit portion arranged on an output end side, each of the first and second filter circuit portions has at least one of the series arm resonators connected to the series arm and at least one of the parallel arm resonators arranged on at least one of the parallel arms, and ends, to be connected to the ground potential, of the first and second filter circuit portions are electrically connected to each other by the ground connection conductor. In this case, grounding in the boundary acoustic wave device is further strengthened.

In still another specific aspect of the boundary acoustic wave device according to the present invention, through holes are provided in the first dielectric layer so as to cause the ground pads to be exposed, and via hole conductors are formed on the inner surfaces of the through holes. In addition, the boundary acoustic wave device further includes under-bump metal layers filled in the through holes and metal bumps provided on the under-bump metal layers. In this case, the boundary acoustic wave device can be easily surface-mounted on a circuit board and the like using metal bumps and a flip chip bonding process, for example.

In still another specific aspect of the boundary acoustic wave device according to the present invention, the boundary acoustic wave device further includes a sound absorbing resin layer which is provided in such a manner as to cover the ground connection conductor or the portion of the signal wiring line formed on the first dielectric layer. By using the sound absorbing resin layer, waves that leak out of the surface of the dielectric layer are reliably absorbed, whereby the attenuation characteristics are improved.

In still another specific aspect of the boundary acoustic wave device according to the present invention, the boundary acoustic wave device further includes a second dielectric layer which is provided in such a manner as to cover the ground connection conductor or the portion of the signal wiring line formed on the first dielectric layer.

In still another specific aspect of the boundary acoustic wave device according to the present invention, the boundary acoustic wave device further includes a second dielectric layer which is provided between the first dielectric layer and the ground connection conductor or the portion of the signal wiring line formed on the first dielectric layer.

### Advantages

In the boundary acoustic wave device according to the present invention, all the ground pads are electrically connected by a ground connection conductor provided on a dielectric layer or a piezoelectric substrate, and hence, compared with the configuration in which respective ground pads are individually connected to a ground potential, grounding is strengthened. In other words, grounding is strengthened because the number of paths along which currents flow to the ground potential is increased. Hence, the attenuation outside of a passband is increased.

In the present invention, since grounding is strengthened using the ground connection conductor provided on the dielectric layer or the piezoelectric substrate, it is not required to provide inductance or capacitance by connection of an external device. Hence, the attenuation outside of the passband can be increased without preventing reduction in size.

### Brief Description of Drawings

[Fig. 1] Fig. 1 (a) is a schematic plan view of a boundary acoustic wave device according to a first embodiment of the present invention, (b) is a front sectional view, and (c) is a partially cut off and magnified front sectional view of the main portions.
[Fig. 2] Fig. 2 is a plan view of a boundary acoustic wave device according to the first embodiment of the present invention.
[Fig. 3] Fig. 3 is a schematic diagram of an electrode structure of a one-port boundary acoustic wave resonator constituting a series arm resonator or a parallel arm resonator.
[Fig. 4] Fig. 4 is a circuit diagram of the boundary acoustic wave device according to the first embodiment.
[Fig. 5] Fig. 5 is a schematic plan view of a boundary acoustic wave device of a first comparative example prepared for comparison with the first embodiment.
[Fig. 6] Fig. 6 is a circuit diagram of the boundary acoustic wave device of the first comparative example shown in Fig. 5.
[Fig. 7] Fig. 7 illustrates the attenuation frequency characteristics of the boundary acoustic wave devices according to the first embodiment and the first comparative example.
[Fig. 8] Fig. 8 is a schematic plan view of a boundary acoustic wave device according to a second embodiment.
[Fig. 9] Fig. 9 illustrates the attenuation frequency characteristics of the boundary acoustic wave devices according to the first and the second embodiments.
[Fig. 10] Fig. 10 is a circuit diagram of a known surface acoustic wave filter device.
[Fig. 11] Fig. 11 is a schematic front sectional view of a boundary acoustic wave device according to a third embodiment of the present invention.
[Fig. 12] Fig. 12 is a schematic front sectional view of a boundary acoustic wave device according to a fourth embodiment of the present invention.

### Best Modes for Carrying Out the Invention

Hereinafter, specific embodiments of the present invention are described with reference to the drawings, thereby clarifying the invention.

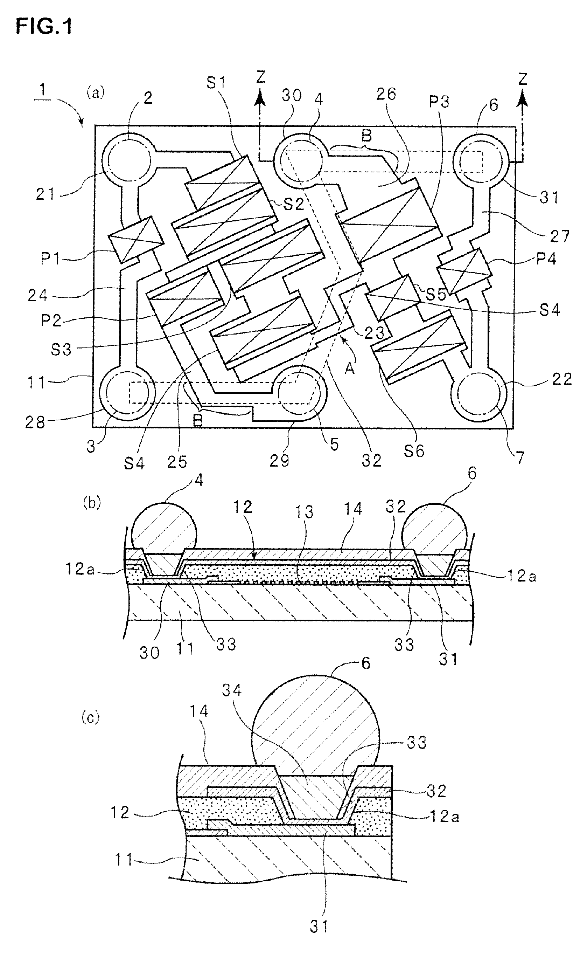

Fig. 1 (a) is an explanatory schematic plan view of the main portions of a boundary acoustic wave filter device according to a first embodiment of the present invention, (b) is a simplified partial front sectional view of the boundary acoustic wave device, and (c) is a partially cut off and magnified front sectional view of the main portions shown in (b).

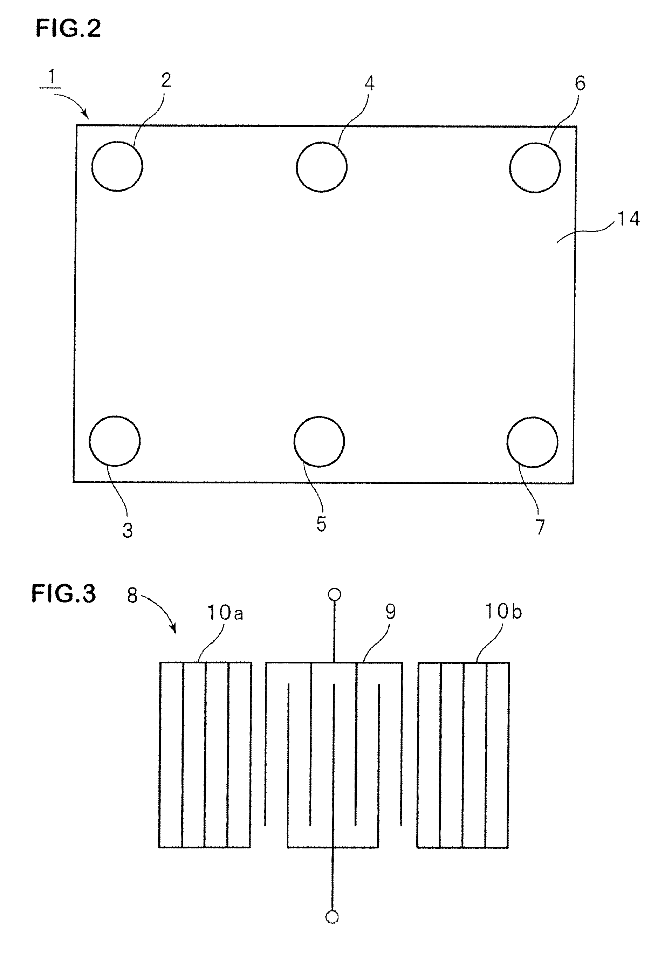

Fig. 2 is a plan view of a boundary acoustic wave device according to the present embodiment.

Referring to Fig. 2, the boundary acoustic wave devise 1 has a planar rectangular shape. The boundary acoustic wave device 1 has metal bumps 2 to 7 arranged on the upper surface thereof. By utilizing the metal bumps 2 to 7, the boundary acoustic wave device 1 can be surface-mounted on a printed circuit board and the like using a flip chip bonding process, for example.

Referring to Fig. 1 (b), the boundary acoustic wave device 1 has a piezoelectric substrate 11. The piezoelectric substrate 11 in the present embodiment is a LiNbO₃ substrate. The piezoelectric substrate 11 is made of a piezoelectric single crystal, such as LiNbO₃, LiTaO₃, and quartz. The piezoelectric substrate 11 may be made of a piezoelectric material other than a piezoelectric single crystal, such as a piezoelectric ceramic.

A dielectric layer 12 is stacked on the upper surface of the piezoelectric substrate 11. The dielectric layer 12 in the present embodiment is a 6 µm thick SiO₂ layer. However, the dielectric layer 12 may be made of an appropriate dielectric material such as inorganic dielectric materials including other dielectric ceramics, SiN etc., or organic dielectric materials inducing synthetic resins.

An electrode structure 13 is formed at the interface between the piezoelectric substrate 11 and the dielectric layer 12. A ladder filter circuit, described later, is made up of the electrode structure 13.

Fig. 1 (b) is a simplified sectional view taken along line Z - Z of Fig. 1 (a). Although the electrode structure 13 does not actually appear in this sectional view, the electrode structure 13 is illustrated in Fig. 1 (b) for ease of understanding.

The electrode structure 13 is made of a metal such as Au, Pt, Al, or Cu; or a metal alloy mainly constituted thereof. The electrode layer constituting the electrode structure 13 may be a stack of a plurality of metal layers.

A sound absorbing resin layer 14 is formed in such a manner as to cover the dielectric layer 12. The sound absorbing resin layer 14 is provided to absorb waves that propagate toward the upper surface side of the dielectric layer 12. Examples of such sound absorbing resins include an appropriate material such as polyimide.

The dielectric layer 12 has a plurality of through holes 12a formed therein. One of the metal bump 2 to 7, described above, is arranged at each position where the through hole 12a is provided. Fig. 1 (a) is a schematic plan view of the electrode structure 13 in the state where the dielectric layer 12, the sound absorbing resin layer 14, and the like have been removed from the boundary acoustic wave device 1.

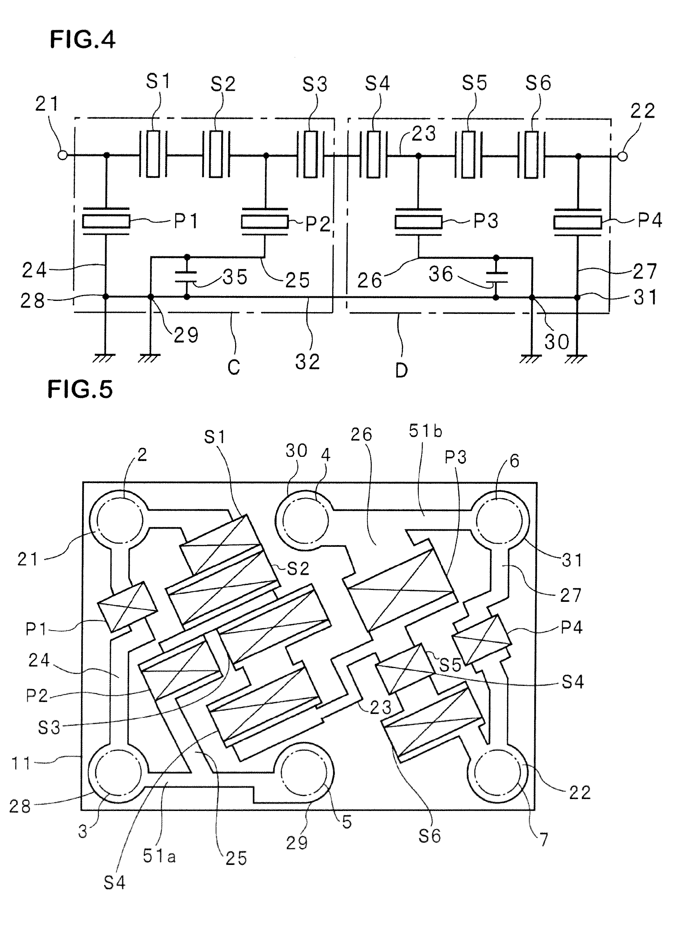

The electrode structure 13 formed on the piezoelectric substrate 11 constitutes a ladder filter circuit having series arm resonators S1 to S6 and parallel arm resonators P1 to P4. Fig. 4 is a circuit diagram of this ladder filter. Each of the series arm resonators S1 to S6 and parallel arm resonators P1 to P4 is a one-port boundary acoustic wave resonator. Fig. 3 illustrates a schematic electrode structure of the one-port boundary acoustic wave resonator. Referring to Fig. 3, the one-port boundary acoustic wave resonator 8 includes an IDT electrode 9 and reflectors 10a and 10b arranged on both sides of the IDT electrode 9 in the boundary acoustic wave propagation direction. The IDT electrode 9 is constituted by a pair of comb electrodes having a mutually interdigitated plurality of electrode fingers.

For ease of illustration, the above-described electrode structure of the one-port boundary acoustic wave resonator is omitted in Fig. 1 (a). In other words, in Fig. 1 (a), the portions provided with the series arm resonators S1 to S6 and the parallel arm resonators P1 to P4 are schematically shown as rectangular boxes each with a cross mark therein.

Referring to Fig. 4, in the ladder circuit configuration of the present embodiment, the series arm resonators S1 to S6 are connected to one another in series on the series arm connecting an input terminal 21 and an output terminal 22. A plurality of parallel arms are connected between the series arm and the ground potential. In other words, a plurality of parallel arms respectively having the parallel arm resonators P1 to P4 are connected between the series arm and the ground potential.

The above-described electrode structure 13 includes signal lines 23 for respectively connecting the series arm resonators S1 to S6 to one another, ground wiring lines 24 to 27, first ends of which are respectively connected to the parallel arm resonators P1 to P4 in order to connect the parallel arm resonators P1 to P4 to the ground potential, and ground pads 28 to 31 respectively connected to the second ends, i.e., ground potential side ends, of the ground wiring lines 24 to 27. The electrode structure 13 also includes the input terminal 21, which is an electrode pad electrically connected to the signal line 23, and the output terminal 22, which is an electrode pad connected to the output side.

In Fig. 1 (a), positions where the above-described metal bumps 2 to 7 are formed are schematically represented by one-dot chain lines. The metal bumps 2 and 7 are metal bumps respectively connected to the input terminal 21 and the output terminal 22. The metal bumps 3 to 6, respectively formed on the ground pads 28 to 31, are metal bumps electrically connected to the ground pads 28 to 31. Here, the series arm connecting the input terminal 21 and the output terminal 22 is located between the ground pads 28 and 29 and the ground pads 30 and 31. When the piezoelectric substrate 11 is reduced in size, there arises such a case where the series arm must be located between at least two ground pads, due to restrictions on the arrangement of the respective resonators and ground pads.

The present embodiment is characterized in that, even when the series arm is located between at least two ground pads, all the ground pads 28 to 31 are electrically connected as shown in Fig. 4, whereby grounding is strengthened. This will be more specifically described below.

Referring to Fig. 1 (a), the dashed line represents a ground connection electrode 32 provided on the upper surface of the dielectric layer 12 described above. The ground connection electrode 32 connects all the ground pads 28 to 31 to one another, thereby strengthening grounding. The ground connection electrode 32 is constituted of an appropriate metal such as Ag, A1, or Cu; or a metal alloy mainly constituted thereof.

Fig. 1 (c) is a schematic sectional view of the portion where the ground pad 31 is formed. The ground pad 31 is electrically connected to the IDT electrode making up the parallel arm resonator P4, by the ground wiring line 27. To expose the ground pad 31, the through hale 12a is formed in the dielectric layer 12. A via hole conductor 33 is formed in such a manner as to cover the inner surface of the through hole 12a. The lower end of the via hole conductor 33 extends to the upper surface of the ground pad 31 so as to be electrically connected thereto. The upper end of the via hole conductor 33 is continuously connected to the ground connection electrode 32. In the present embodiment, the via hole conductor 33 is formed using the same material and process as the ground connection electrode 32; however, the via hole conductor 33 and the ground connection electrode 32 may be individually formed using different materials.

The via hole conductor 33 and the ground connection electrode 32 may be formed using an appropriate method, such as evaporation coating or sputtering.

Note that in Fig. 1 (c) an under-bump metal layer 34 is formed in a portion surrounded by the via hole conductor 33, and the metal bump 6 is formed on the under-bump metal layer 34.

The electrical connection structure of the ground pad 31 and the ground connection electrode 32 has been described. The other ground pads 28 to 30 are similarly exposed in the through holes 12a provided in the dielectric layer 12, and electrically connected to one another by an electrical connection structure between the via hole conductors 33 and the ground connection electrode 32.

In other words, all the ground pads 28 to 31 are electrically connected to one another by the plurality of via hole conductors 33 and the ground connection electrode 32 in the present embodiment. Hence, as shown in Fig. 4, the parallel arm resonators P1 to P4 corresponding to the ground pads 28 to 31 are connected to the ground potential at the ends thereof used for connection to the ground potential, via various paths, whereby the grounding is strengthened. This allows increasing of the attenuation outside of a passband to be realized, as will be described later.

In the present embodiment, the signal line 23 three-dimensionally crosses the ground connection electrode 32 with the dielectric layer 12 therebetween in a portion denoted by an arrow A in Fig. 1 (a). Hence, even when the ground pads 28 and 29 are separated from the ground pads 30 and 31 by the series arm on the piezoelectric substrate 11, all the ground pads 28 to 31 can be electrically connected to one another without increasing the size of the planar shape of the boundary acoustic wave device 1, thereby making it possible to strengthen grounding. In addition, it is preferable to cause the ground connection electrode 32 to three-dimensionally cross a portion of the signal line 23 rather than the IDT electrode as in the present embodiment, since this will not change the characteristics of the filter

Further, in the present embodiment, the ground connection electrode 32 is electrically connected to all the ground pads 28 to 31, and includes facing portions B where the ground connection electrode 32 faces the ground wiring lines 25 and 26 with the dielectric layer 12 therebetween. Hence, capacitance represented by capacitors 35 and 36 shown in Fig. 4 is generated. The generation of this capacitance increases the number of paths connected to the ground potential, thereby realizing further strengthening of grounding, and hence, improvement in the attenuation characteristics outside of the passband.

Note that, in the present embodiment, although all the ground pads 28 to 31 provided on the dielectric layer 12 are commonly connected by the ground connection electrode 32 as shown in Fig. 1 (a), the ground pads 28 and 29 may be electrically connected by a ground connection conductor provided on the piezoelectric substrate. Similarly, the ground pads 30 and 31 may be electrically connected by a ground connection conductor provided on the piezoelectric substrate. In other words, it is not required that all the ground pads 28 to 31 be electrically connected by the ground connection electrode 32 provided on the dielectric substrate 12, as long as all the ground pads 28 to 31 are electrically connected to one another

Hence, it is only required that at least two of the ground pads be electrically connected by the two via hole conductors 33 and the ground connection electrode 32.

Referring to Fig. 4, the series arm resonators S1 to S6 are connected to the series arm, and the parallel arm resonators P1 to P4 are respectively connected to the four parallel arms. In this case, the input terminal 21 side is named the first filter circuit C and the output terminal 22 side is named the second filter circuit D. The first filter circuit C is a portion including the series arm resonators S1 to S3 and the parallel arm resonators P1 to P2, and the second filter circuit D is a portion including the series arm resonators S4 to S6 and the parallel arm resonators P3 to P4. The ground connection electrode 32 electrically connects the ground side ends of the first filter circuit C and the second filter circuit D.

However, the ladder circuit configuration to which the present embodiment is applied is not limited to the configuration shown in Fig. 4. The present invention can be applied to any appropriate ladder filter in which a plurality of series arm resonators are arranged on a series arm and at least one parallel arm resonator is arranged on each of a plurality of parallel arms.

Advantages of the present embodiment will now be described on the basis of an example experiment for comparison with a known example.

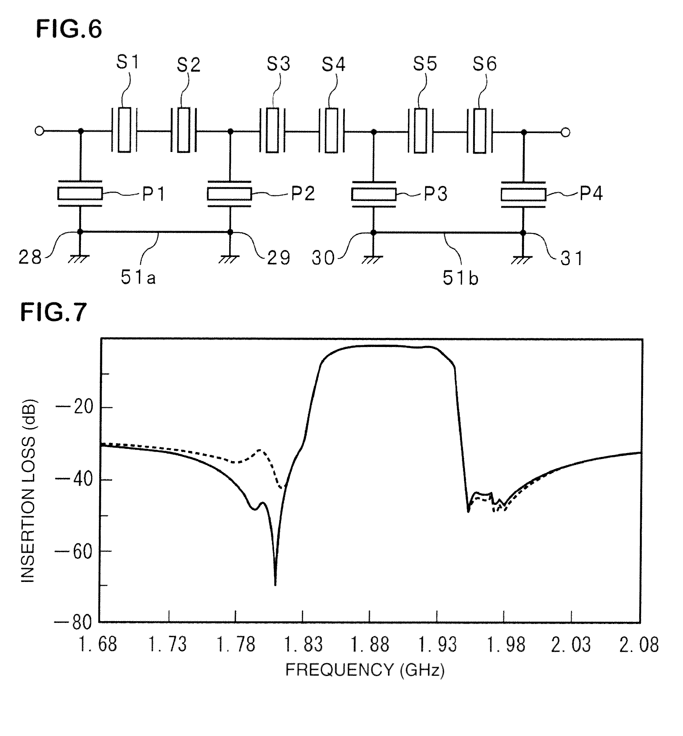

For comparison, a ladder filter having the configuration shown in Fig. 6 has been prepared as a first comparative example. As will be clear from the comparison between Fig. 4 and Fig. 6, in the ladder circuit of the first comparative example, the ground side end of the first parallel arm resonator P1 is not electrically connected to the ground side end of the third parallel arm resonator P3. In other words, the ground side ends of the first filter circuit and the second filter circuit are not electrically connected to each other. Since the other portions of the configuration are the same as those shown in Fig. 4, the same reference numerals are used.

Fig. 5 is a schematic plan view of the boundary acoustic wave device of the first comparative example having the circuit configuration shown in Fig. 6, and corresponds to Fig. 1 (a) showing the above-described embodiment. The two configurations are similar except that, in Fig. 5, the ground connection electrode 32 provided on the dielectric layer 12 is not provided, the ground pads 28 and 29 are electrically connected to each other by a ground connection conductor 51a formed on the piezoelectric substrate 11, and the ground pads 30 and 31 are electrically connected to each other by a ground connection conductor 51b formed on the piezoelectric substrate 11.

Fig. 7 illustrates the attenuation frequency characteristics of the boundary acoustic wave devices of the first embodiment and the first comparative example.

Referring to Fig. 7, the solid line shows the result of the first embodiment, and the dashed line shows the result of the first comparative example. As will be clear from Fig. 7, compared with the first comparative example, the first embodiment allows significant improvement in the attenuation outside of the passband, particularly the attenuation on the lower frequency side of the passband. The reason for this is considered to be that, as described above, grounding has been strengthened since all the ends connected to the ground pads 28 to 31 are electrically connected by the electrical connection structure including the ground connection electrode 32, and grounding has also been strengthened by addition of the capacitors 35 and 36.

Consequently, according to the first embodiment, the attenuation outside of the passband is significantly increased without forming large inductance or capacitance.

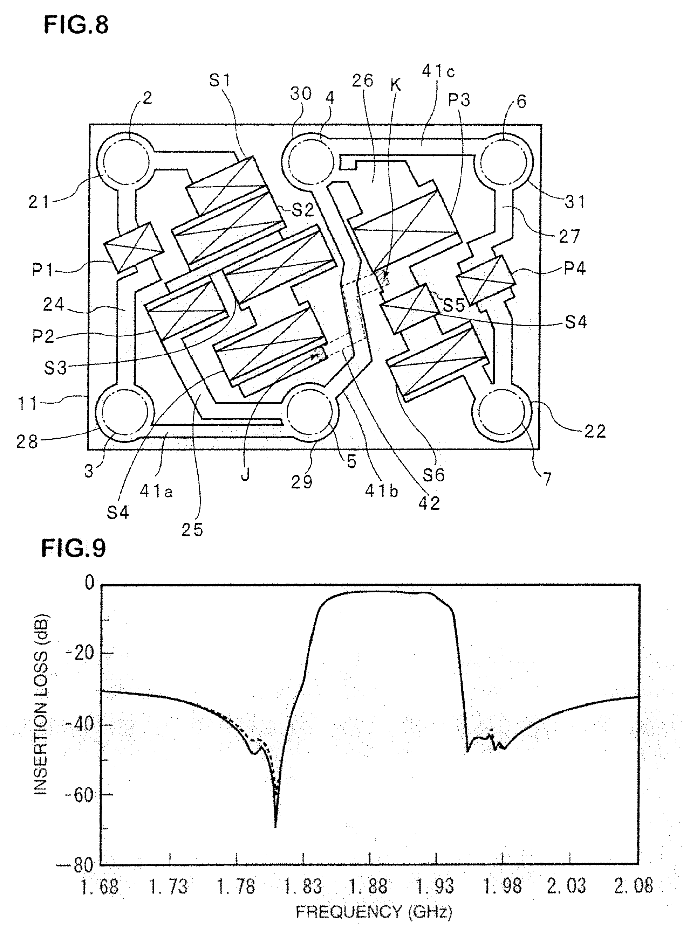

Fig. 8 is a schematic plan view of a boundary acoustic wave device according to a second embodiment, and corresponds to Fig. 1 (a) showing the first embodiment.
In Fig. 8, the ground connection electrode 32 provided on the dielectric layer 12 is not provided, and all the ground pads 28 to 31 are electrically connected by electrode patterns formed on the piezoelectric substrate 11. In other words, the ground pads 28 to 31 are electrically connected by ground connection conductors 41a to 41c formed on the piezoelectric substrate 11. A signal wiring line 42 connecting the series resonators S3 and S4 is caused to three-dimensionally cross the ground connection conductor 41b. In other words, the signal wiring line 42 is a conductor formed on the dielectric layer 12 similarly to the ground connection electrode 32. Referring again to Fig. 8, the series resonators S3 and S4 are electrically connected to the signal wiring line 42 by through holes and via hole conductors provided in the shaded portions denoted by arrows J and K. Thus, as long as all the ground pads 28 to 31 are electrically connected to one another, all the wiring lines for electrical connection may be formed on the upper surface of the piezoelectric substrate 11. Hence, in the second embodiment, the facing portions denoted by B in Fig. 1 (a) are not provided. In other words, in the first embodiment, the facing portions are provided where portions of the ground connection electrode 32 face the ground wiring lines with the dielectric layer 12 therebetween. On the other hand, in the second embodiment shown in Fig. 8, the above-described facing portions are not provided, and the ground wiring line 25 faces a ground connection conductor 41a on the piezoelectric substrate, and the ground wiring line 26 faces a ground connection conductor 41c on the piezoelectric substrate. The other portions of the second embodiment are similar to those of the first embodiment.

Fig. 9 illustrates the attenuation frequency characteristics of the boundary acoustic wave devices of the first embodiment and the second embodiment. The solid line shows the result of the first embodiment, and the dashed line shows the result of the second embodiment. In the second embodiment, the attenuation characteristics on the lower frequency side of the passband are worse than those of the first embodiment. The reason for this is that the ground wiring lines face the ground connection wiring lines only on the piezoelectric substrate, and the facing portions where they face each other with the dielectric layer 12 therebetween are not provided. In other words, this is due to the fact that in the first embodiment, by providing the facing portions B, added capacitance works effectively and further strengthens grounding, whereby the attenuation characteristics outside of the passband are improved. However, compared with the first comparative example described above, the second embodiment also has significantly improved attenuation outside of the passband.

In order for the second embodiment to have the same level of attenuation outside of the passband as the above-described embodiment, capacitance corresponding to that generated by the facing portions B must be added. More specifically, it is considered to be required that capacitors each having a capacitance of 0.05 pF be added between the ground wiring lines connected to the ground side ends of the plurality of the parallel arm resonators provided on the piezoelectric substrate, for example, respectively between the ground wiring lines 25 and 26, and between the ground wiring lines 24 and 27. However, such a configuration will lead to enlargement of the boundary acoustic wave device since capacitors each having a capacitance of 0.05 pF need to be formed on the piezoelectric substrate using the comb electrode pattern. The use of external capacitors instead will cause an increase in the number of parts. Hence, the first embodiment has an advantage over the second embodiment from the viewpoint of both the characteristics outside of the passband and reduction in size.

Although the boundary acoustic wave device 1 having a layer structure in which the sound absorbing resin layer 14 is formed so as to cover the dielectric layer 12 constituted of an SiO₂ layer is shown as an example in the first embodiment, the layer structure of the boundary acoustic wave device 1 according to the present invention is not limited to this. For example, the layer structure may be a layer structure shown in Fig. 11, which is a simplified partial front sectional view of a boundary acoustic wave device according to a third embodiment of the present invention. In other words, in the third embodiment, a second dielectric layer 61 made of SiN is formed on the dielectric layer 12 which is thinner than in the first embodiment. The other portions of the third embodiment are similar to those of the first embodiment.

By providing in this manner, on the dielectric layer 12, the second dielectric layer 61 made of a material such as SiN whose acoustic velocity of transversal waves propagating therethrough is larger than the acoustic velocity of transversal waves propagating through SiO₂, the vibration energy of the boundary acoustic waves can be effectively confined. In the third embodiment, compared with the first embodiment, since the dielectric layer 12 is thinner, the capacitance generated in the facing portions B where portions of the ground connection electrode 32 face the ground wiring lines underneath with the dielectric layer 12 therebetween is larger, whereby the attenuation characteristics outside of the passband are further improved. Although the sound absorbing resin layer 14 is formed on the second dielectric layer 61, the sound absorbing resin layer 14 is not necessarily required.

Fig. 12 is a simplified partial front sectional view of a boundary acoustic wave device according to a fourth embodiment of the present invention. The boundary acoustic wave device 1 of the present invention may use the layer structure shown in Fig. 12. In other words, in the fourth embodiment, a second dielectric layer 62 made of SiN is arranged between the dielectric layer 12 which is thinner than in the first embodiment and the ground connection electrode 32. The other portions of the fourth embodiment are similar to those of the first embodiment. Note that, also in this case, the sound absorbing resin layer 14 is not necessarily required. The fourth embodiment can also improve the attenuation characteristics outside of the passband, similarly to the first embodiment.

Note that although the ground connection electrode 32 is provided on a layer in the third and fourth embodiments similarly to the first embodiment, the signal wiring line 42 may be provided on the layer similarly to the second embodiment. Reference Numerals

- 1: boundary acoustic wave device
- 2 to 7: metal bumps
- 8: one-port boundary acoustic wave resonator
- 9: IDT electrode
- 10a, 10b: reflectors
- 11: piezoelectric substrate
- 12: dielectric layer
- 12a: through hole
- 13: electrode structure
- 14: sound absorbing resin layer
- 21: input terminal
- 22: output terminal
- 23: signal line
- 24 to 27: ground wiring lines
- 28 to 31: ground pads
- 32: ground connection electrode
- 33: via hole conductor
- 34: under-bump metal layer
- 35, 36: capacitors
- 41a to 41c: ground connection conductors
- 42: signal wiring line
- 51a, 51b: ground connection conductors
- 61, 62: second dielectric layers
- P1 to P4: parallel arm resonators
- S1 to S6: series arm resonators

## Claims

1. A boundary acoustic wave device, comprising:
a piezoelectric substrate;
a first dielectric layer formed on the piezoelectric substrate; and
an electrode structure provided at an interface between the piezoelectric substrate and the first dielectric layer,
wherein the electrode structure has: a plurality of series arm resonators connected to one another in series on a series arm that connects an input terminal and an output terminal; a parallel arm resonator connected between the series arm and a ground potential on each of a plurality of parallel arms provided between the series arm and the ground potential; a plurality of ground wiring lines respectively connected to ends, to be connected to the ground potential, of the plurality of the parallel arms; and a plurality of ground pads respectively connected to the plurality of the ground wiring lines, and
wherein the electrode structure constitutes a ladder filter,
the boundary acoustic wave device further comprising:
a signal wiring line constituting the series arm arranged in such a manner as to be located between at least two of the plurality of the ground pads; and
a ground connection conductor for electrically connecting the at least two ground pads,
wherein the signal wiring line three-dimensionally crosses the ground connection conductor with the first dielectric layer therebetween, and
wherein all the ground pads are electrically connected.

2. The boundary acoustic wave device according to Claim 1,
wherein the signal wiring line is formed on the piezoelectric substrate,
wherein the ground connection conductor is formed on the first dielectric layer, and electrically connected to the at least two ground pads through via hole conductors extending through the first dielectric layer, and
wherein the signal wiring line three-dimensionally crosses the ground connection conductor with the first dielectric layer therebetween.

3. The boundary acoustic wave device according to Claim 1 or 2, wherein the ground connection conductor is electrically connected to all the ground pads.

4. The boundary acoustic wave device according to any one of Claims 1 to 3, wherein the boundary acoustic wave device has a facing portion where the ground connection conductor faces the ground wiring line with the first dielectric layer therebetween, and capacitance is formed in the facing portion.

5. The boundary acoustic wave device according to Claim 1,
wherein a portion of the signal wiring line is formed on the first dielectric layer, and is electrically connected to the other portions of the signal line through via hole conductors extending through the first dielectric layer,
wherein the ground connection conductor is formed on the piezoelectric substrate, and
wherein the portion of the signal wiring line three-dimensionally crosses the ground connection conductor with the first dielectric layer therebetween.

6. The boundary acoustic wave device according to any one of Claims 1 to 5, wherein the ladder filter has a first filter circuit portion arranged on an input end side and a second filter circuit portion arranged on an output end side, each of the first and second filter circuit portions has at least one of the series arm resonators connected to the series arm and at least one of the parallel arm resonators arranged on at least one of the parallel arms, and ends, to be connected to the ground potential, of the first and second filter circuit portions are electrically connected to each other by the ground connection conductor.

7. The boundary acoustic wave device according to any one of Claims 1 to 6, wherein through holes are provided in the first dielectric layer so as to cause the ground pads to be exposed, and the via hole conductors are formed on the inner surfaces of the through holes, and the boundary acoustic wave device further comprises under-bump metal layers filled in the through holes and metal bumps provided on the under-bump metal layers.

8. The boundary acoustic wave device according to any one of Claims 1 to 7, further comprising a sound absorbing resin layer provided in such a manner as to cover the ground connection conductor or the portion of the signal wiring line formed on the first dielectric layer.

9. The boundary acoustic wave device according to any one of Claims 1 to 7, further comprising a second dielectric layer provided in such a manner as to cover the ground connection conductor or the portion of the signal wiring line formed on the first dielectric layer.

10. The boundary acoustic wave device according to any one of Claims 1 to 7, further comprising a second dielectric layer provided between the first dielectric layer and the ground connection conductor or the portion of the signal wiring line formed on the first dielectric layer.
